# EUROPEAN PATENT APPLICATION

(11) **EP 4 365 926 A1**
(43) Date of publication of application: **08.05.2024**
(21) Application number: 21948431.8
(22) Date of filing: 01.07.2021
(51) Int. Cl.: H01J 37/20

(54) **CHARGED PARTICLE BEAM DEVICE**

(71) Applicant: Hitachi High-Tech Corporation, Minato-ku Tokyo 105-6409 (JP)
(72) Inventor: KOTSUJI, Hideyuki, Tokyo 100-8280 (JP); YOKOSUKA, Toshiyuki, Tokyo 100-8280 (JP); KAWANO, Hajime, Tokyo 105-6409 (JP)
(74) Representative: Mewburn Ellis LLP
(86) International application number: PCT/JP2021/025045
(87) International publication number: WO 2023/276127

(57) **Abstract**

The present disclosure provides a charged particle beam device capable of removal or control of an electric charge by plasma without affecting control of the charged particle beam. The charged particle beam device according to the present disclosure is provided with a charged particle beam optical system for emitting a charged particle beam onto a sample, a sample chamber provided with a stage on which the sample is placed, a plasma generating device for generating plasma to be emitted onto the stage so as to remove an electrification charge from the sample, and a coupling member coupling the plasma generating device to the sample chamber, the coupling member including an insulating spacer insulating the sample chamber and the plasma generating device.

## Description

### Technical Field

The present invention relates to a charged particle beam device.

### Background Art

As semiconductor patterns become smaller and more highly integrated, slight differences in the shape of the patterns are starting to affect the operating characteristics of devices, and as a result, there is a growing need for shape management of device patterns and the like. Therefore, scanning electron microscopes (SEMs), which are charged particle beam devices used for semiconductor inspection and measurement, are required to have higher sensitivity and accuracy than ever before. A scanning electron microscope is configured such that a detector detects electrons emitted from a sample, generates a signal waveform thereof, and measures, for example, the dimension between peaks (pattern edges).

In wafer inspection during the manufacturing process, early detection of foreign objects and defects leads to improved yields, so there is a growing need for full inspection of wafers for the purpose of detecting defects. However, full inspection has the problem of reducing throughput. To increase the throughput, it is possible to use low magnification imaging using a high current to image a wide field of view at once, but in the case of samples that are easily charged, the effects of charging on the sample due to the low magnification become obvious, and there is a concern that image distortion or uneven brightness may occur. Since charging of the sample causes a decrease in the measurement accuracy of the SEM, it is required to effectively remove the charging.

Known methods for reducing the effects of charging include coating the sample with a conductor to reduce charging, and controlling the yield of secondary electrons by adjusting voltage of primary electrons irradiated. However, such methods cannot be applied to in-line inspection, and are difficult to adjust for samples containing a plurality of materials or samples with patterns of various shapes, making them impractical. Therefore, charge removal and charge control that are independent of the sample are required.

PTL 1 discloses a method of controlling energy of incident electrons as a method of controlling charging of a sample. PTL 2 discloses a method of removing a charge using ions generated when a gas is irradiated with ultraviolet rays or X-rays.

As disclosed in PTL 1, it is possible to control the emission rate of secondary electrons and reduce charging of a sample by changing the energy of primary electrons irradiated onto the sample. However, it is necessary to change the imaging conditions depending on the material properties and pattern of the sample, and each time it is necessary to readjust optical conditions, device settings, and the like, resulting in a problem of reduced throughput.

In PTL 2, a coil supplies high-frequency power to ions generated using ultraviolet rays or X-rays to generate plasma, and the plasma is used to remove charges and contamination of a sample. However, the method of removing the charge is limited to processing before and after imaging the sample, and no consideration is given to the effect of the electric field space created by a condenser lens for controlling an electron beam on the plasma, or to a method of emitting plasma onto the sample to which a voltage was applied to control the emitted electron beam.

### Citation List

### Patent Literature

PTL 1: JP2002-310963A
PTL 2: JP2007-149449A

### Summary of Invention

### Technical Problem

The invention has been made in view of the above-mentioned problems, and provides a charged particle beam device capable of removing or controlling an electric charge by plasma without affecting control of a charged particle beam.

### Solution to Problem

A charged particle beam device according to the invention is a charged particle beam device that emits a charged particle beam onto a sample, and includes a charged particle beam optical system for emitting the charged particle beam onto the sample, a sample chamber provided with a stage on which the sample is placed, a plasma generating device for generating plasma to be emitted onto the stage, and a connecting member that includes an insulating spacer insulating the sample chamber and the plasma generating device and connects the plasma generating device to the sample chamber.

### Advantageous Effects of Invention

According to the invention, it is possible to provide a charged particle beam device capable of removing or controlling an electric charge by plasma without affecting control of a charged particle beam.

### Brief Description of Drawings

[FIG. 1] FIG. 1 is a schematic diagram illustrating the configuration of a charged particle beam device according to a first embodiment.
[FIG. 2] FIG. 2 is a schematic diagram illustrating the operation of the charged particle beam device according to the first embodiment.
[FIG. 3] FIG. 3 is a schematic diagram illustrating the configuration of a charged particle beam device according to a second embodiment.
[FIG. 4A] FIG. 4A is a schematic diagram illustrating the operation of the charged particle beam device according to the second embodiment.
[FIG. 4B] FIG. 4B is a schematic diagram illustrating the operation of the charged particle beam device according to the second embodiment.
[FIG. 4C] FIG. 4C is a graph illustrating the configuration of the charged particle beam device according to the second embodiment.
[FIG. 4D] FIG. 4D is a schematic diagram illustrating the operation of the charged particle beam device according to the second embodiment.
[FIG. 4E] FIG. 4E is a graph illustrating the configuration of the charged particle beam device according to the second embodiment.
[FIG. 5] FIG. 5 is a waveform diagram illustrating the configuration of a charged particle beam device according to a third embodiment.
[FIG. 6] FIG. 6 is a waveform diagram illustrating the configuration of the charged particle beam device according to the third embodiment.
[FIG. 7] FIG. 7 is a schematic diagram illustrating the operation of the charged particle beam device according to the third embodiment.
[FIG. 8] FIG. 8 is a waveform diagram illustrating the operation of the charged particle beam device according to the third embodiment.
[FIG. 9] FIG. 9 is a flowchart illustrating the operation of the charged particle beam device according to the third embodiment.
[FIG. 10] FIG. 10 is a schematic diagram illustrating the configuration of a charged particle beam device according to a fourth embodiment.
[FIG. 11] FIG. 11 is a flowchart illustrating the operation of the charged particle beam device according to the fourth embodiment.
[FIG. 12] FIG. 12 is a schematic diagram illustrating the configuration of a charged particle beam device according to a fifth embodiment.

### Description of Embodiments

Embodiments will be described below with reference to the accompanying drawings. In the accompanying drawings, functionally identical elements may be indicated by the same number. Although the accompanying drawings illustrate embodiments and implementation examples according to the principles of the present disclosure, the drawings are for understanding the disclosure and are not used to interpret the disclosure in a limited way. The description in the specification is merely exemplary and is not intended to limit the scope or application of the claims of the disclosure in any way.

Although the present embodiments are described in sufficient detail to enable those skilled in the art to practice the disclosure, it should be understood that other implementations and forms are possible, and that the configuration and structure can be changed and various elements can be replaced without departing from the scope and spirit of the technical idea of the disclosure. Therefore, the following description should not be construed as being limited to the description.

### [First Embodiment]

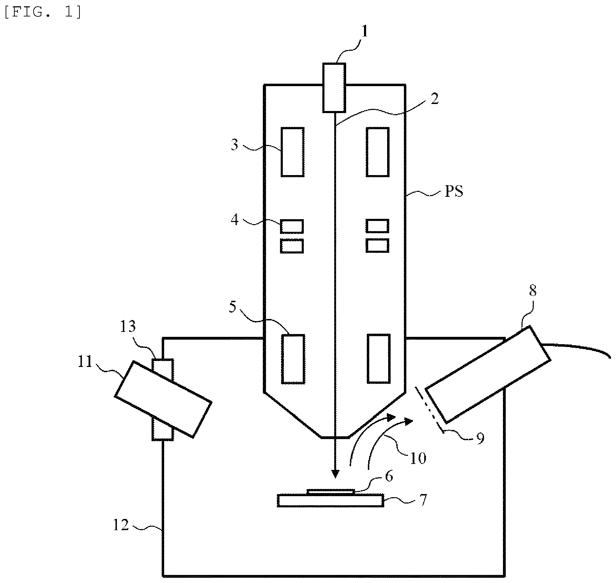

With reference to FIG. 1, a charged particle beam device according to a first embodiment will be described. The charged particle beam device includes, for example, an electron beam optical system PS (charged particle beam optical system) including an electron gun 1, a condenser lens 3, a deflector 4, and an objective lens 5. A sample chamber 12 in which a stage 7 for placing a sample 6 is placed is installed below the electron beam optical system PS.

An electron beam 2 (primary electron beam) generated and accelerated by the electron gun 1 is converged by the condenser lens 3 and further converged by the objective lens 5 onto the sample 6 on the stage 7. The deflector 4 (scanning deflector) causes the electron beam 2 to scan over an electron beam scanning area of the sample 6. By scanning and irradiating the sample 6 with the electron beam 2, electrons excited within the sample 6 are emitted from the sample 6 as secondary electrons 10. The emitted secondary electrons 10 are detected by a secondary electron detector 8, and a calculation unit (not shown) connected to the secondary electron detector 8 converts a detection signal into an image.

An energy filter 9 capable of separating signal electrons based on energy is provided at a front stage (on the incident surface side) of the secondary electron detector 8. It is possible to estimate the charged state of the sample 6 from the change in the detection signal when the voltage applied to the energy filter 9 is changed. The energy of the electron beam 2 (primary electron beam) that scans the sample 6 is determined by the acceleration voltage of the electron gun 1 and the voltage applied to the stage 7. The emitted secondary electrons 10 are related to the energy of the incident primary electrons, and the charged state of the surface of the sample 6 changes depending on the magnitude relationship between an electron flow of the primary electrons and an electron flow of the secondary electrons 10. The amount of charge on the sample 6 also changes depending on the material properties and shape of the sample 6. The amount of charge on the sample 6 is not uniform over the entire surface of the sample 6, but has a distribution that changes depending on the position on the surface of the sample 6 due to material properties, shape, and the like.

The charged particle beam device of the present embodiment includes a plasma generating device 11 that generates plasma and radiates the plasma toward the stage 7 on which the sample 6 is placed to remove the charge on the sample 6. The plasma generating device 11 is connected to the wall surface of the sample chamber 12 by a connecting member 13 including an insulating spacer.

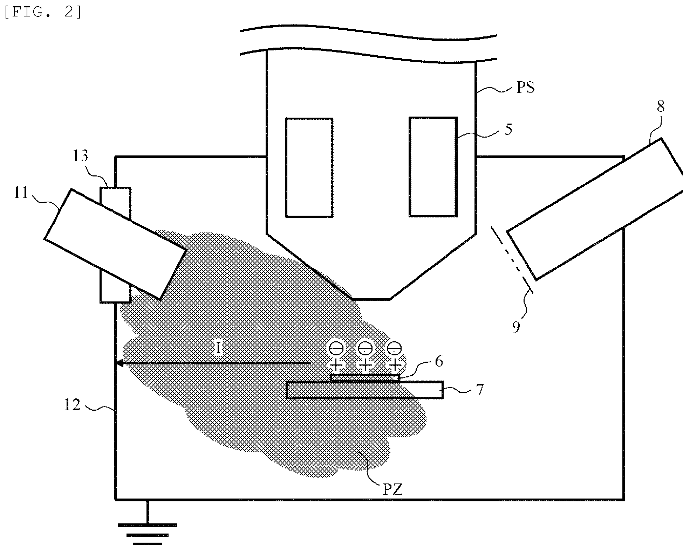

Referring to FIG. 2, the operation of removing static electricity from the sample 6 using the plasma generating device 11 will be described. A plasma PZ generated by the plasma generating device 11 contains electrons and positive ions, and is normally electrically neutral. However, when the positively charged sample 6 is irradiated with plasma, the positive charges on the sample 6 are neutralized by electrons in the plasma. As a result, the electrons in the plasma PZ decrease, the charge balance in the plasma PZ collapses, and a current flows through the plasma PZ to the inner wall of the grounded sample chamber 12 and the like, so that the sample 6 is neutralized.

The plasma generating device 11 is connected to the inner wall of the sample chamber 12 by the connecting member 13 including the insulating spacer. The insulating spacer is made of an insulating material such as ceramics, and has the role of electrically insulating the plasma generating device 11 from the sample chamber 12. Since the plasma generating device 11 is insulated from the sample chamber 12, the potential of the sample chamber 12 can be stably maintained regardless of the operating state of the plasma generating device 11.

### [Second Embodiment]

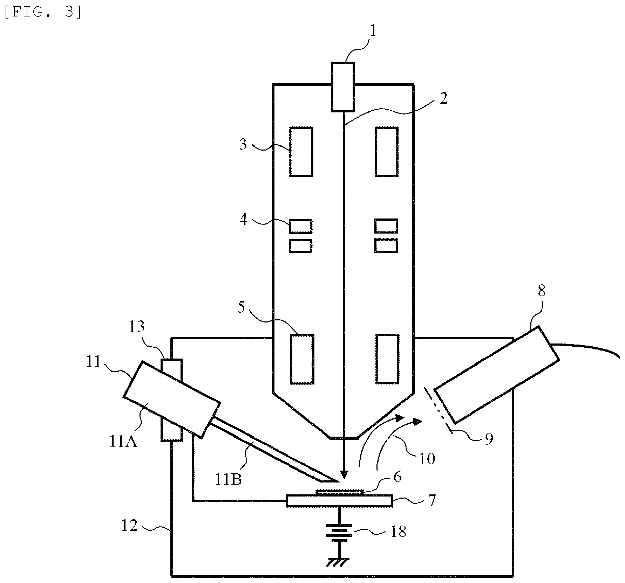

Next, a charged particle beam device according to a second embodiment will be described with reference to FIG. 3. FIG. 3 illustrates the configuration of a charged particle beam device according to the second embodiment. In FIG. 3, components that are the same as those of the charged particle beam device of the first embodiment are denoted by the same reference numerals as in FIG. 1, and therefore, redundant descriptions will be omitted below.

The plasma generating device 11 of the second embodiment is different from the first embodiment in that the plasma generating device 11 of the second embodiment includes a main body portion 11A that generates plasma and a guide 11B that extends from the main body 11A to the vicinity of the sample. The guide 11B is made of metal, and has a hollow portion therein for guiding the plasma PZ generated in the main body portion 11A. The plasma PZ is emitted from the tip of the guide 11B through the hollow portion.

The function of the guide 11B will be described. Since the plasma PZ generated by the plasma generating device 11 has no directivity, if there is no guide 11B, the plasma PZ is diffused from the main body portion 11A into the sample chamber 12 by the electric field and natural diffusion of the plasma PZ itself. If an electric field or the like does not work, the plasma PZ will diffuse into the sample chamber 12. The plasma PZ is attracted by the electric field generated by the charging of the sample 6, so that the charge on the sample 6 can be removed (neutralized). However, the condenser lens 3 and the like for controlling the electron beam 2 are disposed in the electron beam optical system PS connected to the sample chamber 12, and an electric field distribution exists in the sample chamber 12. Such electric field distribution influences the behavior of the plasma PZ. If the influence of the electric field exerted by the condenser lens 3 or the like is large, the operation of removing static electricity by the plasma generating device 11 may be affected. If there is a structure with a potential greater than the electric field distribution exerted by the charges on the sample 6, the charged particles in the plasma PZ will be attracted to the structure, and thus, the plasma PZ cannot sufficiently remove the charge on the sample 6.

On the other hand, in the second embodiment, the charges on the sample 6 lead the plasma PZ to the vicinity of the sample 6 through the guide 11B. As a result, the electrons or positive ions in the plasma PZ neutralize the charges on the sample 6, thereby removing the charges on the sample 6. Since the plasma PZ is guided to the vicinity of the sample 6 by the guide 11B, static elimination of the sample 6 can be performed without being affected by the surrounding electric field.

Since the guide 11B is made of metal, the inside of the guide 11B has the same potential in its length direction, and the plasma PZ can be emitted onto the sample 6 without being affected by an external electric field. Electrons in the plasma PZ emitted from the tip of the guide 11B are attracted to the positive potential on the surface of the sample 6, and neutralize the charges on the sample 6. The charges on the sample 6 are eliminated by flowing as a static elimination current Ir to the guide 11B via the plasma PZ.

The magnitude of the static elimination current Ir depends on the density of the emitted plasma PZ. If the density of the plasma PZ is high, the amount of charged particles for neutralizing charges and the charged particles that mediate the static elimination current Ir also increase. The magnitude of the static elimination current Ir is also affected by the distance between the sample 6, which is the object of static elimination, and the surrounding structures. If the plasma density is the same, the shorter distance also results in lower plasma resistance, allowing more static elimination current Ir to flow. In the present embodiment, static electricity is eliminated by mainly causing the static elimination current Ir to flow through the guide 11B through the plasma PZ. By passing current through the guide 11B disposed close to the sample 6, which is the object of static elimination, rather than through a structure placed far away, such as the inner wall of the sample chamber 12, more efficient static elimination can be performed.

The stage 7 is configured such that a retarding voltage can be applied thereto. The retarding voltage is a voltage for decelerating the electrons of the electron beam 2. The electron beam 2 emitted from the electron gun 1 is converged by the condenser lens 3, the objective lens 5, and the like, and is emitted onto the sample 6. The accelerating voltage of the electron beam 2 emitted from the electron gun 1 is becoming higher for the purpose of improving resolution, but if the energy of the electron beam 2 emitted onto the sample 6 is high, the generation efficiency of the secondary electrons 10 generated from the surface of the sample 6 deteriorates, and charging toward the sample 6 progresses. Depending on the sample 6, the sample may be damaged when irradiated with high-energy electrons. Therefore, a voltage (retarding voltage) that decelerates the electrons before the electrons are emitted onto the sample 6 is applied to the stage 7. Thereby, it is possible to prevent damage and charging of the sample 6 while achieving high resolution of the image. The retarding voltage is applied by a voltage source 18 connected to the stage 7.

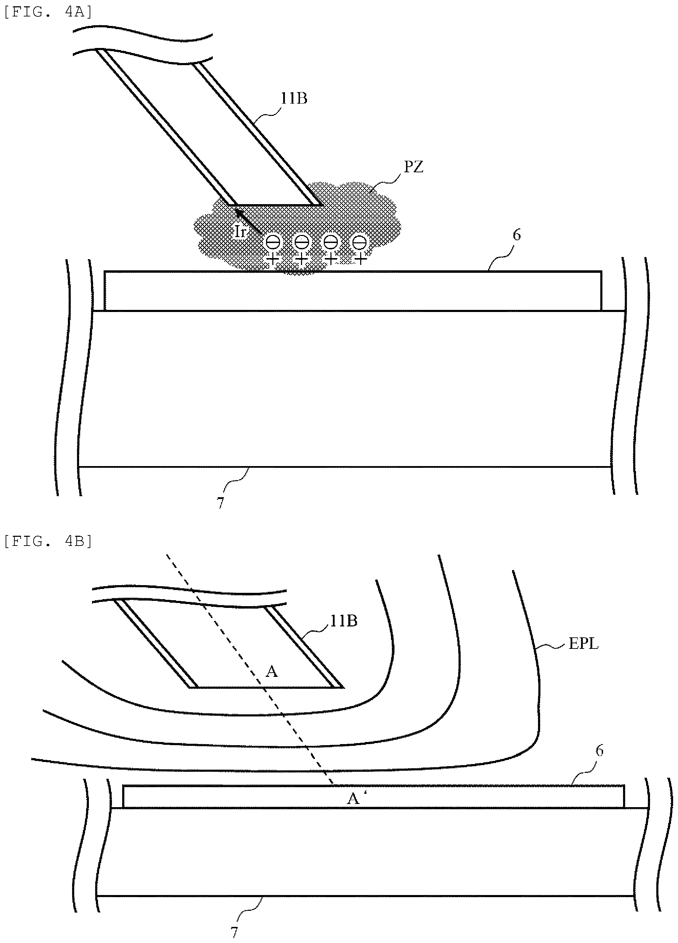

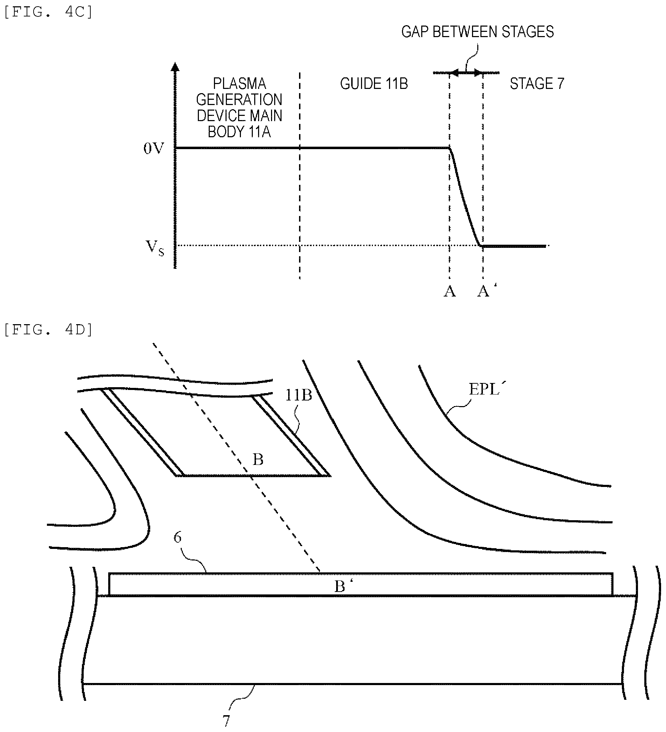

The behavior of the plasma PZ when a voltage is applied to the stage 7 will be described with reference to FIGS. 4A to 4E. As shown in FIG. 4A, the plasma PZ generated in the main body portion 11A of the plasma generating device 11 moves to the vicinity of the sample 6 on the stage 7 through the guide 11B. The plasma PZ is not affected by the electric field of the stage 7 since the main body portion 11A of the plasma generating device 11 and the tip of the guide 11B are electrically connected and have the same potential. However, when no voltage is applied by the voltage source 18, an equipotential line EPL as shown in FIG. 4B is formed in the gap between the tip of the guide 11B and the stage 7, and a potential difference (potential) represented by the equipotential line EPL is generated (see FIG. 4C) . Electrons that cannot exceed the potential difference cannot reach the stage 7 and cannot contribute to removing the charge on the sample 6.

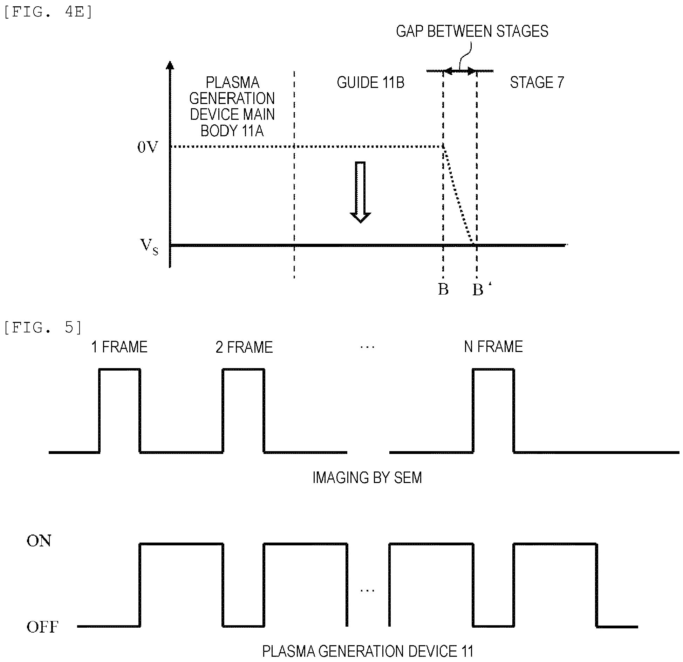

On the other hand, when a voltage is applied to the stage 7 by the voltage source 18, it becomes possible to make the plasma generating device 11 and the stage 7 approximately at the same potential, and the potential distribution (equipotential line EPL') as shown in FIG. 4D is achieved near the tip of the guide 11B. Thus, as shown in FIG. 4E, the potential difference between the plasma generating device 11 and the stage 7 is eliminated, and the plasma PZ is emitted from the tip of the guide 11B onto the sample 6, and thus, it becomes possible to effectively eliminate static electricity.

### [Third Embodiment]

Next, a charged particle beam device according to a third embodiment will be described with reference to FIG. 5. The overall configuration of the charged particle beam device of the third embodiment is substantially the same as that of the above-described embodiment, and therefore, redundant descriptions will be omitted. The third embodiment differs from the previous embodiments in the portion related to control of the plasma generating device 11. Specifically, the plasma generating device 11 of the third embodiment is configured to generate plasma and perform static elimination operation on the sample 6 at timing between a plurality of frames.

In general, when a charged particle beam device images signals captured by the secondary electron detector 8, in addition to generating an image of the sample 6 using one image (frame) obtained in one scan, the charged particle beam device is configured to be able to execute an imaging mode that generates an image with high resolution (SN ratio) by scanning the same field of view of the sample 6 a plurality of times and combining (overlapping) the plurality of images obtained to generate a composite image. On the other hand, if the number of times the electron beam 2 is emitted increases by repeating the imaging operation a plurality of times within the same field of view, the amount of charge on the sample 6 caused by the electron beam 2 increases. An increase in the amount of charge on the sample 6 may affect not only the electron beam 2 but also the secondary electrons 10.

Therefore, as shown in FIG. 5, the charged particle beam device of the third embodiment is configured to perform the static elimination operation of the plasma generating device 11 between the imaging of a plurality of frames. As shown in FIG. 5, by differentiating the timing of the SEM imaging (each frame) and the static elimination operation of the plasma generating device 11, static elimination of the sample 6 can be performed without affecting the imaging.

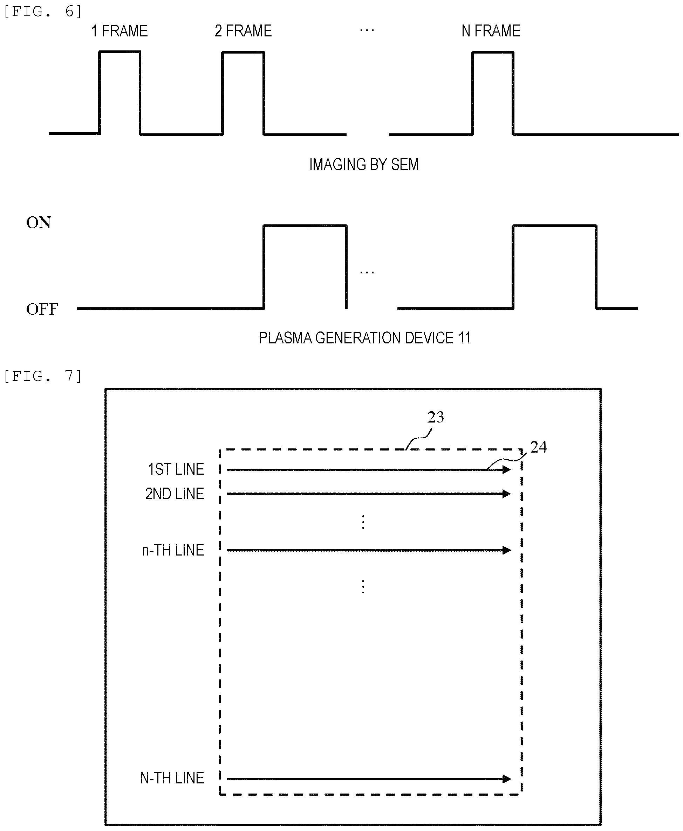

By performing the static elimination operation by the plasma generating device 11 for each frame, it is possible to remove the static electricity generated in each frame during imaging, reduce the influence on the image due to the accumulation of static electricity in each frame, and enabling stable image acquisition. Although FIG. 5 adopts a sequence in which the plasma generating device 11 executes the static elimination operation every frame, as shown in FIG. 6, it is also possible to adopt a sequence in which the static elimination operation is performed once every multiple frames. As the number of static elimination operations inserted between imaging increases, the imaging throughput decreases accordingly. By inserting the static elimination operation within a range where the influence of charging caused by primary electrons does not substantially occur, the static elimination operation can be performed while preventing a decrease in throughput. Note that the term "imaging" herein refers to the period up to when the secondary electrons 10 emitted by the primary electrons entering the sample 6 are detected by the secondary electron detector 8. Turning on the plasma generating device 11 in FIGS. 5, 6, and the like means the period during which an ON signal is input to the plasma generating device 11, the plasma PZ is generated, static elimination is executed, and an OFF signal is input to the plasma generating device 11.

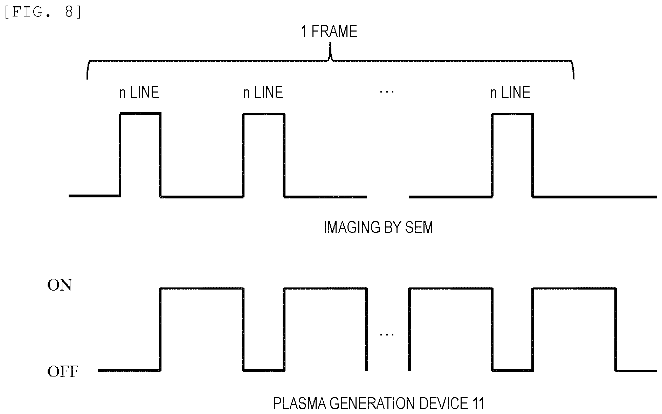

Note that although FIGS. 5 and 6 illustrate an example in which the static elimination operation is performed between two frames, the charged particle beam device of the disclosure is not limited thereto. It is also possible to adopt a procedure in which the static elimination operation is executed once every time the imaging of a plurality of frames is completed, for example. Alternatively, as shown in FIGS. 7 and 8, it is also possible to configure the plasma generating device 11 to be turned on and execute the static elimination operation between line scans.

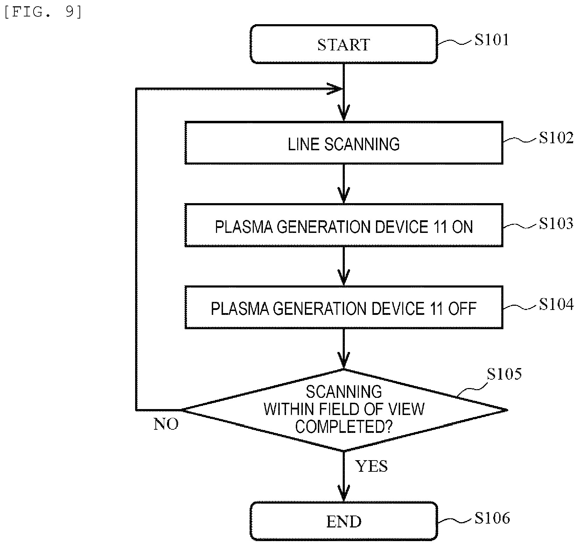

FIG. 9 is a flowchart illustrating a procedure for executing a static elimination operation every time a predetermined number of lines are scanned in the third embodiment. After scanning one or a plurality of lines (step S102), the plasma generating device 11 is turned on to execute the static elimination operation (step S103), and then the plasma generating device 11 is turned off (step S104) . Thereafter, the same operation is repeated until scanning within a specified field of view is completed (step S105) .

Generally, in a charged particle beam device, an image is taken by scanning a specified field of view of the sample 6 using the electron beam 2 by scanning a plurality of lines. In FIG. 7, the electron beam 2 is emitted from left to right on the page, and then the electron beam 2 is sequentially emitted toward the bottom of the page. Scanning of the electron beam 2 is controlled by the deflector 4. As the number of scanned lines increases, the charge on the sample 6 also increases, and the influence on the electron beam 2 and secondary electrons 10 also increases. The amount of charge caused by irradiation with the electron beam 2 also changes depending on the imaging conditions of the SEM and the pattern shape and material of the sample 6. By executing static elimination after scanning a certain number of lines as shown in FIG. 9, it is possible to remove charge according to the amount of charge and the effect on the image, which makes it possible to remove charge while minimizing the decrease in throughput.

### [Fourth Embodiment]

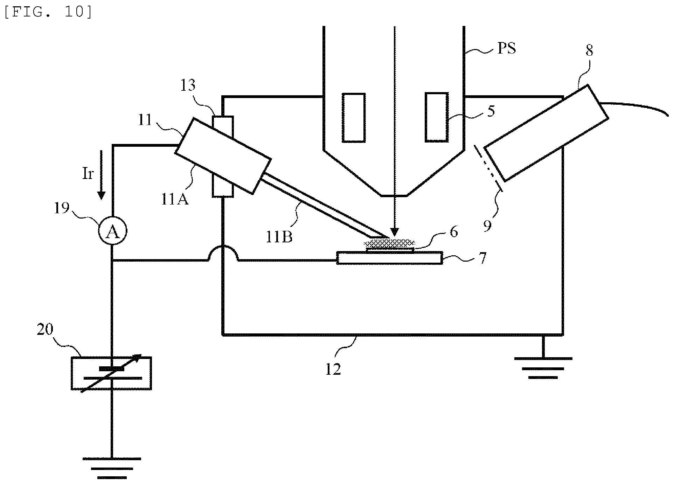

Next, a charged particle beam device according to a fourth embodiment will be described with reference to FIG. 10. In FIG. 10, components that are the same as those of the charged particle beam device of the first embodiment are denoted by the same reference numerals as in FIG. 1, and therefore, redundant descriptions will be omitted below.

The charged particle beam device of the fourth embodiment is different from the embodiments mentioned above in that the charged particle beam device is provided with a current measuring device 19 that measures the magnitude of the static elimination current Ir, and performs the static elimination operation according to the measurement result. The current measuring device 19 may be connected to a current path connecting the stage 7 and the plasma generating device 11, for example. A voltage source 20 for applying a predetermined potential can be connected to the current path.

In static elimination using the plasma PZ, the plasma PZ is emitted toward the sample 6, thereby neutralizing the charge on the sample 6 with electrons or positive ions in the plasma PZ. Neutralization disrupts the charge balance between electrons and positive ions in the plasma PZ, and the static elimination current Ir flows through the plasma PZ, thereby performing static elimination. Since the static elimination current Ir flows to the plasma generating device 11 via the plasma PZ, the static elimination current Ir is measured by connecting the current measuring device 19 to the current path connecting the plasma generating device 11 and the stage 7. The amount of charge on the sample 6 can be evaluated based on the magnitude of the static elimination current Ir.

As another method for evaluating the amount of charge, it is possible to estimate the amount of charge on the sample 6 from the change in the detection signal when the voltage applied to the energy filter 9 is changed. However, here, it is necessary to sweep the applied voltage. The energy filter 9 selects the secondary electrons 10 that can be detected by excluding the secondary electrons 10 having energy equal to or less than the applied voltage, thereby increasing the resolution of the image. Therefore, in normal wafer inspection, the energy filter 9 is used without changing the voltage of the energy filter 9. Therefore, due to the action of the energy filter 9, it is difficult to measure the amount of charge on the sample 6 during inspection.

According to the fourth embodiment, the charged state of the sample 6 can be known even during inspection of the sample 6 by measuring the magnitude and polarity of the static elimination current Ir flowing when the static elimination operation is executed by the plasma PZ. If the imaging conditions are the same, the amount of charge on the sample 6 depends on the material properties and the sample pattern, and thus, it is possible to monitor the amount of charge and detect abnormalities in the sample 6 or the like from the amount of change. For example, if there is a defect in the shape of a pattern that is easily charged, the amount of charge on the sample 6 will change. Therefore, according to the present embodiment, it is possible to detect the occurrence of an abnormality such as a defect in the shape of the sample 6.

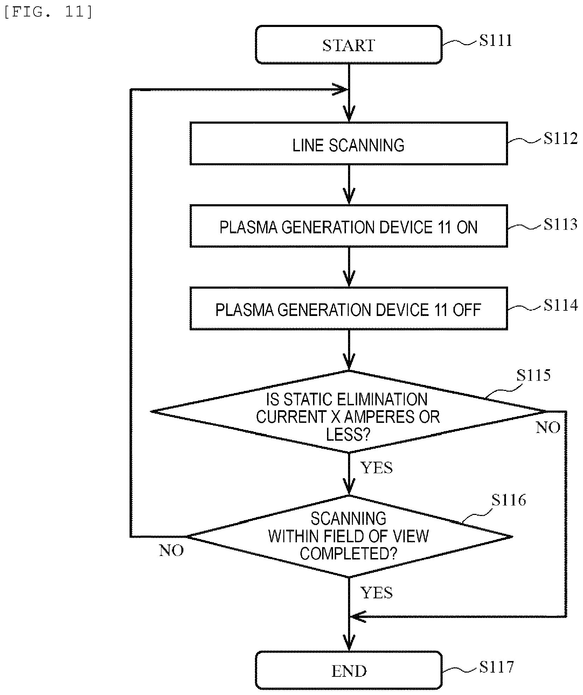

With reference to the flowchart of FIG. 11, the measurement operation (static elimination operation) of the sample 6 in the charged particle beam device of the fourth embodiment will be described. After scanning one or a plurality of lines (step S112), the plasma generating device 11 is turned on to execute the static elimination operation (step S113), and then the plasma generating device 11 is turned off (step S114). Thereafter, it is determined whether the static elimination current detected by the current measuring device 19 during the static elimination operation is equal to or less than X amperes (threshold value) (step S115). If the determination is positive, there is no problem with the measurement of the sample 6, so the process proceeds to step S116, and the above operations are repeated until the scanning within the specified field of view is completed (step S105). On the other hand, if the determination in step S115 is negative, it is determined that an abnormality has occurred in the sample 6, the imaging operation of the sample 6 is stopped, and the procedure of FIG. 11 ends (step S117).

As described above, according to the fourth embodiment, the same effects as those of the above embodiments can be obtained. By measuring the static elimination current using the current measuring device 19, it becomes possible to detect abnormalities regarding the sample 6.

### [Fifth Embodiment]

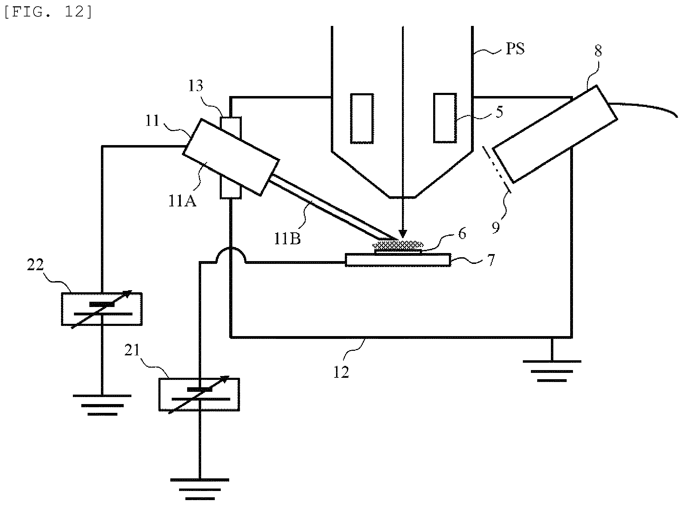

Next, a charged particle beam device according to a fifth embodiment will be described with reference to FIG. 12. In FIG. 12, components that are the same as those of the charged particle beam device of the first embodiment are denoted by the same reference numerals as in FIG. 1, and therefore, redundant descriptions will be omitted below. The charged particle beam device of the fifth embodiment differs from the above-described embodiments in that the stage 7 and the plasma generating device 11 are connected to different voltage sources 21 and 22, respectively, and are given different potentials.

In the embodiment described above, the case where the potential of the main body portion 11A and the guide 11B of the plasma generating device 11 is made equal to the potential of the stage 7 has been described. Accordingly, the potential difference between the tip of the guide 11B and the stage 7 is eliminated, thereby making it possible to emit the plasma PZ onto the sample 6 without being affected by the surrounding electric field. In contrast, in the fourth embodiment, the potential applied to the main body portion 11A and the guide 11B of the plasma generating device 11 can be set to a different potential from the potential applied to the stage 7.

A voltage Vₛ is applied to the stage 7 by a voltage source 21 to adjust the energy of the electron beam 2 (primary electrons) incident on the sample 6. On the other hand, a voltage V₁ different from the voltage Vₛ is applied to the plasma generating device 11. The voltage Vₛ applied to the stage 7 varies depending on the pattern shape, material, and the like of the sample 6 in addition to the imaging conditions, but if various conditions are constant, the polarity and potential of the charge will be constant. By freely changing the voltage V₁ of the voltage source 19, it is possible to generate a potential difference between the stage 7 and the guide 11B, change the balance of electrons or positive ions, and selectively irradiate more of one of the electrons and the positive ions. For example, if the charge on the sample 6 is negative, a negative potential difference can be generated between the guide 11B and the stage 7 by lowering the voltage V₁ of the voltage source 22 with respect to the voltage Vₛ of the voltage source 21. Thereby, more positive ions can be extracted from the plasma PZ, making it possible to eliminate static electricity more efficiently. On the contrary, if the charge on the sample 6 is positive, a positive potential difference can be generated between the guide 11B and the stage 7 by increasing the voltage V₁ of the voltage source 22 with respect to the voltage Vₛ of the voltage source 21. Thereby, more negative ions can be extracted from the plasma PZ, making it possible to eliminate static electricity more efficiently.

In static elimination using plasma, the positive charge on the sample 6 is neutralized by electrons in the plasma, and the negative charge on the sample 6 is neutralized by positive ions. Therefore, if the charge polarity is unknown or has a distribution, static electricity can be removed more efficiently if the ion balance of electrons and positive ions is the same. However, as shown above, if the conditions are constant, the energy filter 9 makes it possible to grasp the charged state in advance, and the charged state and polarity can be identified. By adjusting the voltage sources 21 and 22 according to the identified charged state and polarity, a more efficient static elimination operation can be performed.

The invention is not limited to the above-described embodiments, and includes various modifications. For example, the embodiments described above are described in detail to describe the invention in an easy-to-understand manner, and is not necessarily limited to those having all the configurations described. It is possible to replace a part of the configuration of one embodiment with the configuration of another embodiment, and it is also possible to add the configuration of the other embodiment to the configuration of another embodiment. It is possible to add, delete, or replace another configuration for a part of the configuration of each embodiment. Each of the above components, functions, processing parts, processing units, and the like, may be implemented in hardware, for example, by designing as integrated circuits, in whole or in part. Each of the above configurations, functions, and the like may be implemented by software by a processor interpreting and executing programs for implementing each function. Information such as programs, tables, and files that implement each function can be stored in a recording device such as memory, hard disk, solid state drive (SSD), or a recording medium such as IC card, SD card, and DVD.

### Reference Signs List

1: electron gun
2: electron beam
3: condenser lens
4: deflector
5: objective lens
6: sample
7: stage
8: secondary electron detector
9: energy filter
10: secondary electron
11: plasma generating device
11A: main body portion
11B: guide
12: sample chamber
PZ: plasma
13: connecting member
16: equipotential line
18, 21, 22: voltage source
19: current measuring device

## Claims

1. A charged particle beam device for emitting a charged particle beam onto a sample, the charged particle beam device comprising:
a charged particle beam optical system for emitting the charged particle beam onto the sample;
a sample chamber provided with a stage on which the sample is placed;
a plasma generating device for generating plasma to be emitted onto the stage; and
a connecting member that includes an insulating spacer insulating the sample chamber and the plasma generating device, and connects the plasma generating device to the sample chamber.

2. The charged particle beam device according to claim 1, wherein the plasma generating device includes a main body that generates plasma, and a guide extending from the main body in a direction toward the stage.

3. The charged particle beam device according to claim 1, wherein the stage is provided with a voltage source that provides approximately the same potential as the potential of the plasma generating device.

4. The charged particle beam device according to claim 1, wherein the plasma generating device is configured to generate plasma between frames for imaging the sample and execute a static elimination operation on the sample.

5. The charged particle beam device according to claim 1, wherein the plasma generating device is configured to generate plasma during a plurality of line scans for imaging the sample and execute a static elimination operation on the sample.

6. The charged particle beam device according to claim 1, further comprising a current measuring device for measuring a static elimination current flowing through the plasma generating device.

7. The charged particle beam device according to claim 6, wherein the imaging operation of the sample is stopped when the static elimination current measured by the current measuring device exceeds a predetermined threshold value.

8. The charged particle beam device according to claim 1, further comprising:
a first voltage source for applying a potential to the stage; and
a second voltage source for applying a potential to the plasma generating device.

9. A charged particle beam device for emitting a charged particle beam onto a sample, the charged particle beam device comprising:
a charged particle beam optical system for emitting the charged particle beam onto the sample;
a sample chamber provided with a stage on which the sample is placed; and
a plasma generating device for generating plasma to be emitted onto the stage, wherein
the plasma generating device includes
a main body that generates plasma, and a guide extending from the main body in a direction toward the stage.

10. The charged particle beam device according to claim 9, wherein the stage is provided with a voltage source that provides approximately the same potential as the potential of the plasma generating device.

11. The charged particle beam device according to claim 9, wherein the plasma generating device is configured to generate plasma between frames for imaging the sample and execute a static elimination operation on the sample.

12. The charged particle beam device according to claim 9, wherein the plasma generating device is configured to generate plasma during a plurality of line scans for imaging the sample and execute a static elimination operation on the sample.

13. The charged particle beam device according to claim 9, further comprising a current measuring device for measuring a static elimination current flowing through the plasma generating device.

14. The charged particle beam device according to claim 13, wherein the imaging operation of the sample is stopped when the static elimination current measured by the current measuring device exceeds a predetermined threshold value.

15. The charged particle beam device according to claim 9, further comprising:
a first voltage source for applying a potential to the stage; and
a second voltage source for applying a potential to the plasma generating device.
